# DEMANDE DE BREVET EUROPEEN

(11) **EP 0 926 502 A2**
(43) Date de publication de la demande: **30.06.1999**
(21) Numéro de dépôt: 98403221.9
(22) Date de dépôt: 18.12.1998
(51) Int. Cl.: G01R 29/10

(54) **Système optoélectronique de test d'une antenne**

(30) Priorité: 23.12.1997 FR 9716337
(71) Demandeur: THOMSON-CSF, 75008 Paris (FR)
(72) Inventeur: d'Auria, Luigi, 94117 Arcueil Cedex (FR); Chazelas, Jean, 94117 Arcueil Cedex (FR); Renaud, Jean-Charles, 94117 Arcueil Cedex (FR); Lailler, Maxime, 94117 Arcueil Cedex (FR)

(57) **Abrégé**

Ce système optoélectronique de test comporte :
- une antenne de test (AT) destinée à être placée dans le champ d'émission ou de réception d'une antenne (AN) ;
- un composant optoélectronique (MD) associé à l'antenne de test recevant et émettant alternativement des signaux optiques de/vers des émetteurs/récepteurs optique distants et recevant et/ou émettant des signaux électriques de/vers l'antenne de test ;
- un circuit électrique d'adaptation connecté entre le composant optoélectronique (MD) et l'antenne de test.

Ce système permet ainsi de tester à demeure une antenne (par exemple une antenne Radar) sans perturber le diagramme de rayonnement de celle-ci.

Ce composant semiconducteur est donc alternativement modulateur ou détecteur de rayonnement lumineux et il est raccordé par fibres optiques à des émetteurs et des détecteurs adaptés situés hors du champ de l'antenne à tester.

Les câbles composés de matériaux diélectriques ne perturbent pas le diagramme de rayonnement des antennes.

Un système optoélectronique permet de s'affranchir des variations des caractéristiques du composant semiconducteur, évitant notamment une stabilisation en température de celui-ci.

Application : Test d'antennes.

## Description

L'invention concerne un système optoélectronique de test d'une antenne, plus particulièrement l'invention concerne un dispositif optoélectronique alternativement émetteur ou détecteur de signaux radiofréquence et permettant notamment de tester à demeure une antenne (par exemple une antenne radar) sans perturber le diagramme de rayonnement de celle-ci.

Des dispositifs de tests optoélectroniques d'antennes ont déjà été réalisés. Pour faire des tests d'une antenne aussi bien en émission qu'en réception, ils font appel à un assemblage de plusieurs composants électroniques dédiés d'une part au test en émission et d'autre part au test en réception. Ils peuvent donc comporter :
- soit une photodiode et une diode laser
- soit une photodiode et un modulateur électrooptique.

Les alimentations de ces dispositifs sont en général effectuées par des moyens locaux (piles par exemple).

L'invention concerne un système de test permettant d'utiliser un composant optoélectronique unique et prévoyant une téléalimentation déportée.

Le dispositif est essentiellement constitué d'une antenne reliée à un composant semiconducteur unique alternativement modulateur ou détecteur de rayonnement lumineux raccordé par fibres optiques à des émetteurs et des détecteurs adaptés situés hors du champ de l'antenne à tester.

Les câbles composés de matériaux diélectriques ne perturbent pas le diagramme de rayonnement des antennes.

Un système optoélectronique permet de s'affranchir des variations des caractéristiques du composant semiconducteur, évitant notamment une stabilisation en température de celui-ci.

L'invention concerne donc un système optoélectronique de test d'une antenne principale, caractérisé en ce qu'il comporte :
- une antenne de test destinée à être placée dans le champ d'émission/réception de l'antenne principale;
- un composant optoélectronique détecteur/modulateur d'une onde lumineuse capable de détecter une première onde lumineuse et de fournir un courant électrique de commande et également capable de moduler une deuxième onde lumineuse sous la commande d'un courant électronique de modulation;
- un circuit électrique d'adaptation connecté entre le composant optoélectronique et l'antenne de test recevant, d'une part, du composant optoélectronique le courant électrique de commande et commandant l'émission de l'antenne de test et recevant, d'autre part, de l'antenne de test un courant électrique et commandant le composant optoélectronique en mode modulation;
- une première source optique émettant la première onde lumineuse vers le composant optoélectronique;
- une deuxième source optique émettant la deuxième onde lumineuse vers le composant optoélectronique ;
- un détecteur optoélectronique coupé optiquement au composant optoélectronique et détectant une onde modulée par ce composant.

Les différents objets et caractéristiques de l'invention apparaîtront plus clairement dans la description qui va suivre et dans les figures annexées qui représentent :
- la figure 1, un diagramme général du système de test selon l'invention ;
- la figure 2, un diagramme du système de l'invention prévoyant une opto-alimentation du système ;
- la figure 3, un exemple de réalisation du composant modulateur/détecteur utilisé dans le système de test ;
- la figure 4, un exemple de caractéristique longueur d'onde/température du composant de la figure 3 ;
- la figure 5, un exemple de circuit électronique d'adaptation et de commande de l'antenne de test.

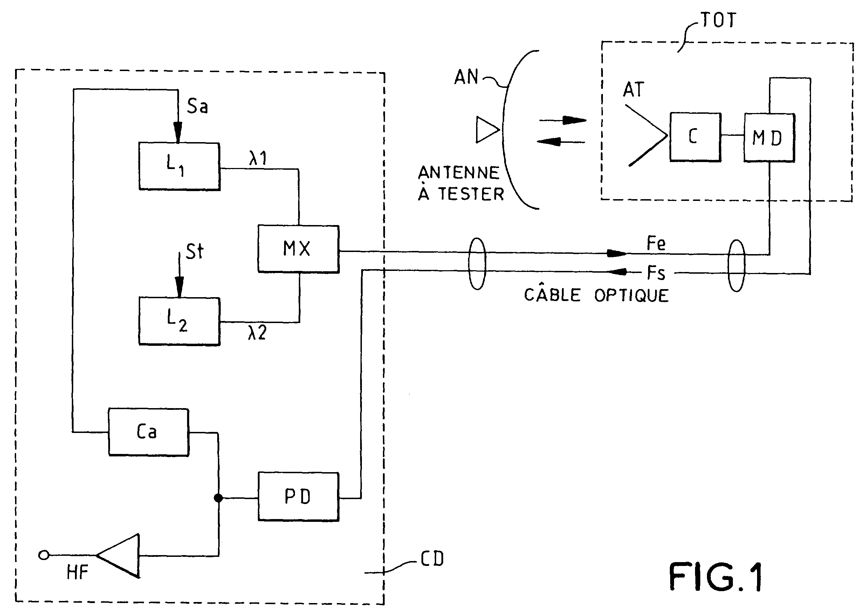

En se reportant à la figure 1, on va tout d'abord décrire un diagramme de réalisation du système de l'invention.

Ce système comporte une tête optique de test TOT destinée à être placée dans le champ d'émission/réception d'une antenne à tester AN. Il est bien évident que sur la figure 1, les dimensions respectives des différents éléments et leurs distances les uns par rapport aux autres n'ont pas été respectées.

La tête optique de test TOT proprement dite comporte un composant optoélectronique MD pouvant alternativement moduler ou détecter une onde optique guidée. Le composant MD est relié électriquement à une antenne de test AT via un circuit électronique adaptation et de commande C et optiquement à des circuits distants CD. Cette liaison distante peut être faite avec des fibres telles qu'une fibre optique entrante Fe et une fibre optique sortante Fs.

La fibre optique entrante Fe est raccordée via un multiplexeur optique MX à deux émetteurs laser L₁ et L₂ émettant respectivement des longueurs d'onde λ₁ et λ₂. L₁ est un émetteur accordable autour de la longueur λ₁ commandé par un signal Sa issu d'un circuit Ca. L₂ est un émetteur laser capable d'émettre des signaux modulés par un signal radiofréquence St.

La fibre optique sortante Fs est raccordée à une photodiode PD1 compatible des radiofréquences et munie d'une sortie électrique haute fréquence HF et d'une sortie continue (ou basse fréquence) connectée au circuit de commande d'accord Ca de l'émetteur laser L₁.

Les fibres optiques Fe et Fs sont en matériau diélectrique et ne perturbent pas le diagramme de rayon de l'antenne. Le composant MD est prévu pour détecter la longueur d'onde λ₂ de façon à ce que le courant détecté commande par l'intermédiaire du circuit C l'émission par l'antenne de test AT d'une onde hyperfréquence vers l'antenne à tester AN.

Le composant MD est également prévu pour moduler la longueur d'onde λ₁ sous la commande d'un courant fournit par le circuit C et résultant d'une détection par l'antenne de test AT.

En mode de réception de l'antenne à tester AN, l'émetteur laser L₂ est modulé par un signal radiofréquence de test St. Ce signal, imprimé au rayonnement lumineux à la longueur d'onde λ₂ émis par L₂ est dirigé via le multiplexeur MX et la fibre optique Fe sur le composant optoélectronique MD agissant en tant que photorécepteur ; il est transformé en signal électrique et commande, au travers du circuit C, l'antenne AT, qui a son tour émet ce signal de test vers l'antenne à tester AN.

L'antenne à tester AN détecte ce signal et l'identifie. Après analyse des caractéristiques de ce signal, il est possible d'en déduire les propriétés de l'antenne AN en réception.

En mode d'émission de l'antenne à tester AN, celle-ci émet une onde. Une partie du rayonnement électromagnétique émis est capté par l'antenne AT et est transformée en une tension de commande du composant optoélectronique MD agissant en tant que modulateur de lumière. Par ailleurs, sous la commande d'un moyen non représenté ce rayonnement optique continu à la longueur d'onde λ₁ issu de l'émetteur L₁ est transmis via le multiplexeur MX et la fibre optique Fe à l'entrée de MD. Ce rayonnement à la longueur d'onde λ₁ est modulé dans le modulateur MD par le signal capté par l'antenne de test AT. Le signal optique modulé issu de MD est conduit grâce à la fibre optique Fs vers le photorécepteur PD1 qui le transforme en signal électrique disponible sur la sortie HF. Un circuit CF détecte la fréquence de modulation et la compare avec la fréquence d'émission de l'antenne AN pour l'identifier. Les caractéristiques du signal permettent d'en déduire les propriétés de l'antenne AN en émission.

### Modulateur/détecteur (MD)

La fonction optoélectronique de l'invention réalisée par le composant MD modulateur/détecteur consiste donc :
1) à détecter un signal lumineux à une longueur d'onde λ₂ et le transformer en un signal électrique ;
2) à moduler un signal lumineux continu se propageant à la longueur d'onde λ₁.

Ces deux fonctions sont réalisées par le même composant semiconducteur et pendant des phases de temps alternées.

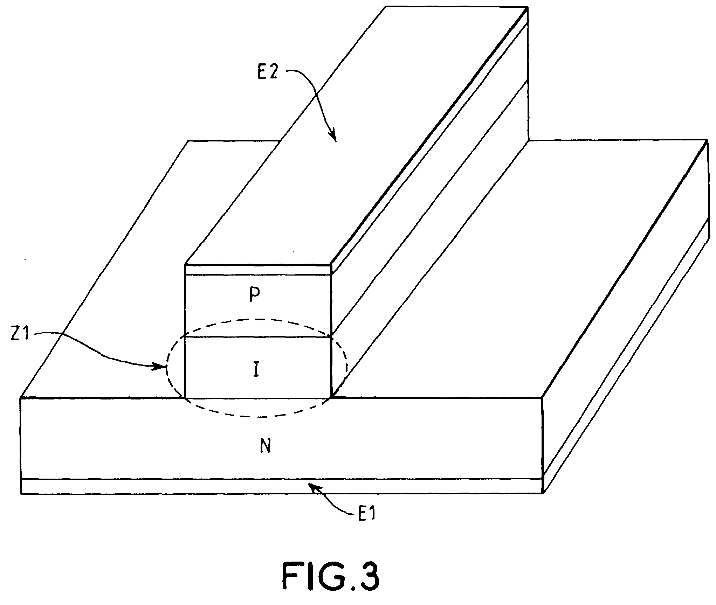

La figure 3 représente un exemple de réalisation d'un dispositif modulateur/détecteur selon l'invention. Ce dispositif comporte un empilement de couches de matériaux semiconducteurs formant un guide d'onde. Par exemple, il comporte sur un substrat en InP dopé N une couche active d'alliage quaternaire GaInAsP non dopé et la composition correspond à une énergie E_{Q} de 0,82 eV (où λ_{Q} = 1,5 µm en longueur d'onde) et une couche en InP dopée P. Une délimitation géométrique par photolithographie de ces couches est réalisée pour obtenir un guide d'onde ainsi qu'une jonction PIN de taille réduite.

De part et d'autre de ces couches, des électrodes E₁ et E₂ permettent de polariser la jonction. Les faces du dispositif perpendiculaires à la direction du guide sont clivées ou gravées avec un angle de 90°. Le composant reçoit la lumière dans la zone Z1, c'est-à-dire par la tranche. Un traitement anti-réfléchissant de cette face permet d'optimiser le rendement de collection des photons et donc d'améliorer la détectivité et l'efficacité de modulation.

En mode d'émission de la tête optique de test, un signal lumineux de longueur d'onde λ₂ est focalisé sur le détecteur dans la zone Z1. Pour que ce signal soit détecté efficacement par le dispositif, il faut que λ₂ < λ_{Q}. Dans l'exemple précédent où λ_{Q} = 1,5 µm la longueur d'onde λ₂ pourrait être issue d'un laser standard émettant à 1,3 µm. Les photons du signal λ₂ sont alors guidés dans la couche active et absorbés durant cette propagation, puis transformés en courant électrique. Le composant peut fonctionner sans tension appliquée (0 V) mais sa détectivité et sa vitesse sont améliorées par une tension légèrement négative (typiquement -2V) appliquée aux bornes des électrodes E1 et E2.

En mode de réception, la tête optique de test aura pour fonction de moduler le signal lumineux continu de longueur d'onde λ₁. Pour obtenir l'effet de modulation, λ₁ sera sensiblement supérieur à λ_{Q} (typiquement λ₁ = 1,55 µm quand λ_{Q} = 1,5 µm) ; une tension modulée autour d'une valeur négative permet de faire varier le front d'absorption du matériau actif et donc d'absorber ou non la lumière. Cet effet se traduit par une modulation de l'intensité du signal. Comme dans le cas de la photodétection, le signal est focalisé dans la zone Z1. Suivant la modulation de tension appliquée, le matériau actif sera absorbant ou transparent et le signal sera ainsi modulé.

Le choix du matériau quaternaire actif est fonction des conditions opératoires, en particulier de λ₁ et λ₂ et aussi de la température de travail du dispositif.

La lumière guidée dans le guide d'onde et modulée par la tension appliquée aux électrodes, ressort du guide d'onde par la zone Z2 et est transmise à la photodiode PD1.

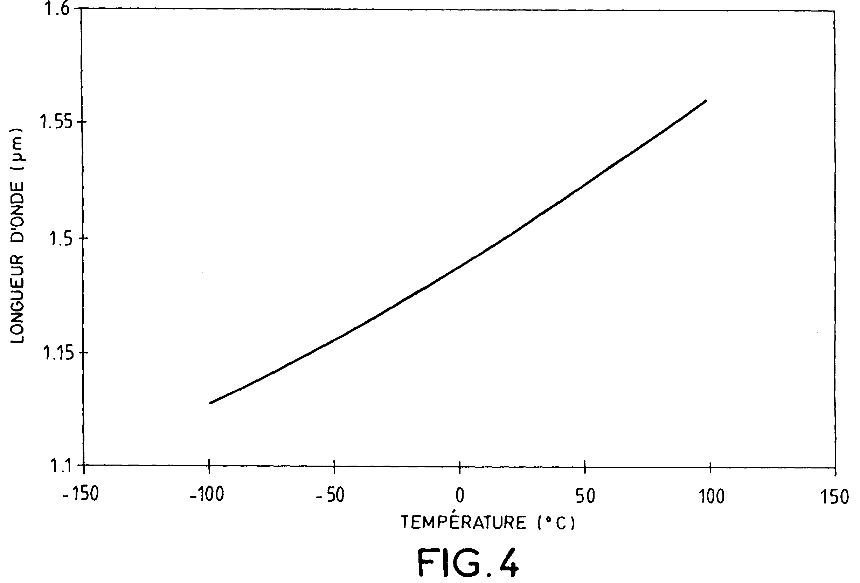

La figure 4 montre les variations typiques de λ_{Q} en fonction de la température.

Ce composant MD modulateur/détecteur nécessite un ajustage précis de la longueur d'onde d'absorption en mode modulateur. Cette longueur d'onde peut être continûment optimisée en agissant sur la longueur d'onde d'émission de la source L1. Pour cela un circuit Ca détecte le niveau de réception du photodétecteur PD1 et agit par un signal Sa sur la longueur d'onde d'émission λ₁ de la source L1 de façon à avoir un maximum d'énergie lumineuse transmise et détectée par le photodétecteur PD1.

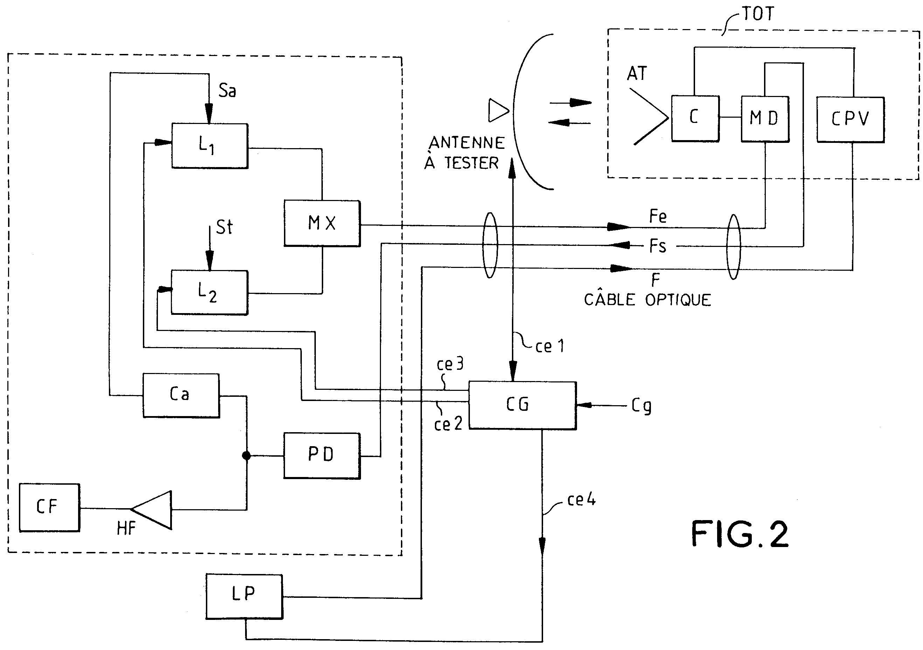

L'alimentation électrique de la tête optique de test TOT peut être classiquement assurée par une pile associée aux circuits de la tête TOT (alimentation non représentée), soit comme cela est représenté en figure 2, par un photodétecteur PD2 recevant une onde lumineuse d'alimentation qui est convertie en énergie électrique. Selon la figure 2, l'onde lumineuse d'alimentation est émise par une diode laser de puissance LP adaptée à la longueur d'onde de sensibilité du photodétecteur PD2 et est transmise par une fibre optique F. Cette fibre tient donc lieu de câble d'alimentation ; elle est en matériau diélectrique et ne perturbe pas le diagramme de rayonnement de l'antenne AN.

L'alimentation de la TOT est dimensionnée de manière à assurer :
- le fonctionnement du composant optoélectronique émetteur/modulateur MD (tension de polarisation de MD pour la fonction détection et la fonction modulation) ;
- les fonctions de protection et de vérification de bon fonctionnement de la tête optique test TOT assurées par le circuit électronique C d'adaptation et de commande.

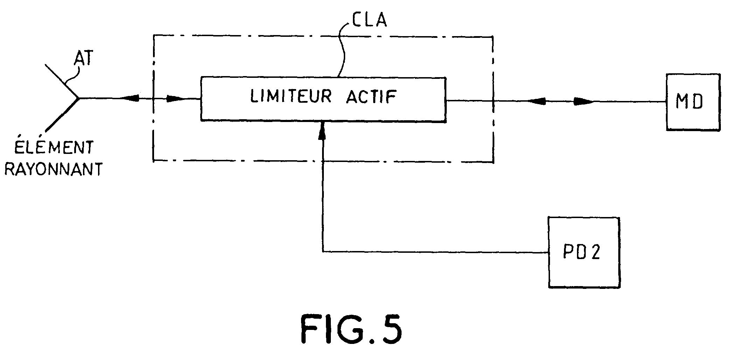

Les diverses fonctions assurées par le circuit électronique C (figure 5) seront mieux comprises en exposant les différents modes de fonctionnement de la TOT par exemple devant une antenne AN de radar :
- radar en émission (dit mode normal)
- test, radar en réception
- test, radar en émission
- vérification de bon fonctionnement de la TOT

En mode normal de fonctionnement en émission radar, la TOT est protégée contre le champ rayonné grâce à un circuit de protection (limiteur actif compatible des champs délivrés par le système d'émission, réciproque, de faible perte d'insertion lorsqu'il n'est pas activé et de forte perte d'insertion de valeur connues lorsqu'il est activé). Ce circuit de protection est activé par une commande ce4 venant de CG et passant par LP. La TOT ne modifie pas le fonctionnement normal du radar.

En mode de test et de calibration de l'antenne AN en réception, le circuit de protection est désactivé par la valeur de la tension d'alimentation, liée à la puissance émise par le laser LP et reçue par le photodétecteur PD2. La TOT est alors en mode émission. Le composant MD est utilisé comme une photodiode et délivre directement à l'élément rayonnant AT le signal hyperfréquence reçu va la fibre optique Fe.

En mode de test de l'antenne AN en émission, le radar émet à puissance normale. Le circuit de protection est activé, il assure une forte perte d'insertion de valeur connue. La TOT est en mode réception et un signal proportionnel au signal reçu par AT est directement adressé au composant MD utilisé comme modulateur de la lumière reçue par la fibre Fe.

La vérification de bon fonctionnement de la TOT est effectuée lorsque le radar émet. Une modulation de la lumière émise par LP a pour conséquence de moduler la tension d'alimentation du circuit de protection. Cette modulation est répercutée sur le signal hyperfréquence reçu du radar via AT et sera traduite par le composant MD en une modulation de la lumière reçue par Fe. La modulation retransmise par Fs est alors disponible sur le photodétecteur PD1. L'analyse du signal permet de vérifier le bon fonctionnement de la TOT en mode réception et de déterminer la fonction de transfert de la TOT.

Pour mettre en oeuvre ce fonctionnement, le système comporte par exemple un circuit de gestion CG commandé par des moyens non représentés. Le circuit CG commande la mise en veille de l'antenne AN, puis successivement le test en mode émission et en mode réception.

Pour le test en mode émission, le circuit CG commande par la liaison ce1, l'émission par l'antenne AN d'une onde ayant une longueur d'onde caractéristique. Cette onde est reçue par l'antenne de test AT et le modulateur MD. Parallèlement, le circuit CG commande par la liaison ce2 l'émission par la source L1 d'une onde λ₂ qui est transmise au composant MD. Celui-ci module l'onde λ₁ sous la commande du signal transmis par l'antenne de test AT. L'onde modulée est transmise à la photodiode PD qui détecte cette onde et fournit un signal électrique correspondant. Ce signal est transmis au circuit de détection CF qui détecte la modulation et identifie le signal reçu. Le signal est ainsi à même d'indiquer le bon fonctionnement (ou non) de l'antenne AN.

Pour le test en mode réception de l'antenne AN, le circuit CG commande, par la liaison ce3, l'émission par la source L1 d'une onde λ₁. Celle-ci est détectée par le composant MD qui fournit un signal électrique à l'antenne de test AT, laquelle émet une onde de test vers l'antenne AN. Celle-ci détecte l'onde de test et permet ainsi d'indiquer le bon fonctionnement ou non.

### Laser L1

L1 peut être une diode laser GaInAsP émettant dans la fenêtre 1,5 µm et accordable dans la zone de fluctuation de la longueur d'onde d'absorption du composant MD fonctionnant en mode modulateur.

La tête optique de test TOT peut être prévue pour fonctionner dans une gamme de température de -40°C à +80°C, soit une variation de la longueur d'onde d'absorption de l'ordre de 80 nm.

Une gamme d'accordabilité de cet ordre peut être facilement obtenue grâce à une diode laser Perot-Fabry munie d'une cavité externe dont on fait varier mécaniquement la longueur par la commande électrique Sa d'un élément piézoélectrique. La puissance optique émise est de l'ordre de 10 mW.

### Laser L2

L2 est une diode laser GaInAsP de type Perot-Fabry ou à résonateur distribué (DFB) selon le rapport signal/bruit recherché. Ce laser émet une puissance de l'ordre de 10 mW dans la fenêtre 1,3 µm (classique en télécommunications par fibres optiques) sans aucune précision particulière en longueur d'onde et est modulable en hyperfréquence selon l'application visée par exemple autour de 10 GHz pour le test d'un radar bande X.

### Photodiode PD1

Toujours dans le cas du test en bande X, PD1 sera une photodiode planar GaInAs présentant une capacité de l'ordre de 0,1 pF et une sensibilité de l'ordre de 0,8 A/W.

### Multiplexeur MX

Il s'agit d'un composant optique passif utilisé classiquement en télécommunications optiques et basé par exemple sur l'utilisation d'un miroir dichroïque. Son rôle est de coupler dans la fibre entrante Fe les énergies lumineuses issues simultanément des lasers L1 et L2 émettant respectivement dans les fenêtres 1,5 et 1,3 µm.

### Circuit Ca

Ca est un circuit électronique d'asservissement de la longueur d'onde d'émission de L1 de manière à l'ajuster à la longueur d'onde d'absorption de MD au moment du test. Pour ce faire, Ca recherche le signal Sa, commandant L1, provoquant l'amplitude maximum du signal détecté par la photodiode PD.

### Avantages de l'invention

- Les câbles diélectriques (ou fibres optiques) ne perturbant pas le diagramme de rayonnement de l'antenne à tester en mode émission.
- Volume réduit de l'ensemble tête optique de test.
- Faible nombre de composants (un composant optoélectronique unique assure la modulation et la détection optiques).
- Système d'asservissement optimisant la longueur d'onde d'absorption et permettant notamment de s'affranchir dans la TOT de tout dispositif de régulation en température, tel que par exemple un thermoélément, consommant de l'énergie électrique et augmentant le volume et le coût.
- Possibilité d'utiliser plusieurs têtes optiques de test situées à des endroits différents devant l'antenne AN et permettant d'effectuer des tests plus sophistiqués.

## Revendications

1. Système optoélectronique de test d'une antenne (AN), caractérisé en ce qu'il comporte :
- une antenne de test (AT) destinée à être placée dans le champ d'émission ou de réception d'une antenne (AN) ;
- un composant optoélectronique (MD) associé à l'antenne de test recevant et émettant alternativement des signaux optiques de/vers des circuits d'émission/réception optique distants et recevant et/ou émettant des signaux électriques de/vers l'antenne de test ;
- un circuit électrique d'adaptation connecté entre le composant optoélectronique (MD) et l'antenne de test.

2. Système optoélectronique de test d'une antenne (AN), caractérisé en ce que :
- le composant optoélectronique (MD) est capable de détecter une première onde lumineuse (λ₂) et de fournir un courant électrique de commande ;
- le circuit électrique d'adaptation connecté entre le composant optoélectronique (MD) et l'antenne de test (AT) reçoit du composant optoélectronique (MD) le courant électrique de commande et commande l'émission de l'antenne de test ;
- la première source optique (L2) émet la première onde lumineuse (λ₂) vers le composant optoélectronique (MD).

3. Système optoélectronique de test d'une antenne (AN), caractérisé en ce que :
- le composant optoélectronique (MD est capable de moduler une deuxième onde lumineuse (λ₁) sous la commande d'un courant électrique de modulation ;
- le circuit électrique d'adaptation connecté entre le composant optoélectronique (MD) et l'antenne de test (AT) reçoit de l'antenne de test (AT) un courant électrique et commande le composant optoélectronique (MD) en mode modulation ;
- une deuxième source optique (L1) émet la deuxième onde lumineuse vers le composant optoélectronique (MD) ;
- un détecteur optoélectronique (PD1) coupé optiquement au composant optoélectronique (MD) et détectant une onde modulée par ce composant.

4. Système selon la revendication 1, caractérisé en ce que le composant optoélectronique (MD) comporte :
- un empilement de couches de matériaux semiconducteur fournissant une jonction PIN et permettant le guidage d'une onde optique selon le plan des couches ;
- des électrodes E1 et E2 situées de part et d'autre des couches et permettant de polariser la jonction ;
- une face de réception de la lumière perpendiculaire au plan des couches et permettant l'entrée de la lumière dans le guide ;
- une face d'émission de la lumière également perpendiculaire au plan des couches et permettant une émission de l'onde modulée.

5. Système selon la revendication 4, caractérisé en ce que l'empilement de couches comporte une couche active dont la composition correspond à une énergie EQ telle que la première onde (λ₂) soit absorbée (λ₂ < λ_{Q}), la deuxième onde lumineuse ayant une longueur d'onde supérieure à λ_{Q}.

6. Système selon la revendication 1, caractérisé en ce qu'il comporte une cellule photodétecteur (PD2) capable de recevoir un faisceau lumineux d'une source lumineuse (LP) et d'alimenter en courant le circuit électronique d'adaptation de protection et de commande (C) et le composant optoélectronique (MD).

7. Système selon l'une des revendications 1 ou 6, caractérisé en ce que les transmissions optiques entre, d'une part, le composant optoélectronique (MD) et, d'autre part, les sources optiques (L1, L2) et le détecteur optoélectronique (PD1) ainsi qu'entre le photodétecteur (PD2) et la source lumineuse (LP) se font en optique non guidée.

8. Système selon l'une des revendications 1 ou 6, caractérisé en ce que les transmissions optiques entre, d'une part, le composant optoélectronique (MD) et, d'autre part, les sources optiques (L1, L2) et le détecteur optoélectronique (PD1) ainsi qu'entre la cellule photovoltaïque et la source lumineuse (LP) se font en optique guidée.

9. Système selon la revendication 8, caractérisé en ce que lesdites transmissions se font à l'aide de fibres optiques (Fe, Fs, F).

10. Système selon la revendication 9, caractérisé en ce que les transmissions entre le composant optoélectronique (MD) d'une part et la première et la deuxième source optique (L2, L1) se font à l'aide d'une fibre optique commune (F2), lesdites sources (L2, L1) étant connectées à la fibre optique commune par un circuit de multiplexage (MX).

11. Système selon la revendication 3, caractérisé en ce qu'il comporte un circuit électrique de détection (Ca) de niveau de courant connecté au détecteur optoélectronique (PD1) et fournissant un signal de commande (Sa) fonction du niveau de courant détecté, ledit signal de commande étant fourni à la deuxième source (L1) pour régler la longueur d'onde (λ₁) émise.

12. Système selon l'une des revendications 2 ou 3, caractérisé en ce qu'il comporte un circuit de gestion (CG) du fonctionnement de l'antenne principale (AN) et du système optoélectronique de test, ce circuit comprenant une entrée de commande sur laquelle est reçue un signal de commande de test et fournissant :
- sur une première sortie un signal commandant la mise en veille du radar ;
- sur une deuxième et troisième sorties, des signaux commandant à des temps différents d'une part l'émission par l'antenne principale (AN) d'une onde de test et l'émission par la deuxième source (L1) de la deuxième onde lumineuse et d'autre part la commande d'émission par la première source (L2) de la première onde lumineuse ;
- sur une quatrième sortie des signaux (Ce4) commandant le niveau d'émission du laser (LP) d'alimentation de la tête optique de test.

13. Système selon la revendication 12, caractérisé en ce qu'il comporte un circuit de limiteur actif (CLA) situé entre l'antenne (AN) et ledit composant optoélectronique (MD) permettant d'introduire une forte perte d'insertion dans le circuit lorsque l'antenne (AN) est commandée en mode émission ou de n'introduire qu'une faible perte d'insertion lorsque l'antenne de test (AT) est commandée en mode émission.

14. Système selon la revendication 13, caractérisé en ce que le circuit limiteur actif (CLA) est activé par le circuit de gestion (CG) en même temps qu'il commande l'émission par l'antenne (AN).

15. Système selon la revendication 13, caractérisé en ce que le circuit limiteur (CLA) est désactivé en raison de la tension d'alimentation liée à la puissance reçue par le photodétecteur (PD2).

16. Système selon l'une des revendications 6 ou 13, caractérisé en ce qu'un circuit de gestion (CG) commande le test de fonctionnement du système optoélectronique de test en commandant la modulation de la lumière émise par ladite source lumineuse (LP) de façon à ce que la lumière modulée module le fonctionnement du circuit limiteur (CLA), laquelle modulation est répercutée sur le signal transmis par l'antenne de test (AT) au composant optoélectronique (MP) et au photodétecteur (PD1), des moyens d'analyse de signaux étant connectés au photodétecteur (PD1).
